# EUROPÄISCHE PATENTSCHRIFT

(11) **EP 0 890 268 B1**
(45) Veröffentlichungstag und Bekanntmachung des Hinweises auf die Patenterteilung: **02.01.2003**
(21) Anmeldenummer: 97916326.8
(22) Anmeldetag: 04.03.1997
(51) Int. Cl.: H04Q 1/14

(54) **SCHUTZBAUGRUPPE FÜR EINEN VERTEILER IN EINER TELEKOMMUNIKATIONSANLAGE**
PROTECTIVE MODULE FOR A TELECOMMUNICATION SYSTEM DISTRIBUTOR
MODULE DE PROTECTION POUR REPARTITEUR D'UN SYSTEME DE TELECOMMUNICATIONS

(30) Priorität: 28.03.1996 DE 19612447
(43) Veröffentlichungstag der Anmeldung: 13.01.1999
(73) Patentinhaber: CCS Technology, Inc., Wilmington, DE 19803 (US)
(72) Erfinder: BRENNER, Wolfgang, D-82223 Eichenau (DE); HECHENBERGER, Alfred, D-85221 Dachau (DE); HERZOG, Kurt, D-81737 München (DE); KUNZE, Dieter, D-82061 Neuried (DE)
(74) Vertreter: Sturm, Christoph, Dipl.-Ing.
(86) Internationale Anmeldenummer: DE9700415
(87) Internationale Veröffentlichungsnummer: WO97036467

(56) Entgegenhaltungen:
- EP-A- 0 204 675
- EP-A- 0 208 926
- EP-A- 0 258 629
- EP-A- 0 446 433

## Beschreibung

Die Erfindung bezieht sich auf eine Schutzbaugruppe zum. Anstecken an ein Kontaktbauteil eines Verteilers in einer Telekommunikationsanlage.

Eine derartige Schutzbaugruppe ist z.B. durch die EP 0 258 629 A1 bekannt geworden. Danach ist ein Kontaktbauteil mit einer Vielzahl von Kontaktteilen zum Anschluß von ankommenden und abgehenden Leitungen versehen. Die Kontaktteile sind mit rückseitigen Steckkontakten verbunden, die mit einer entsprechenden Vielzahl von Steckkontaktstellen der Schutzbaugruppe kontaktierbar sind. Die Schutzbaugruppe ist von der der Bedienseite abgewandten Rückseite des Kontaktbauteils her an die Steckkontakte anschaltbar. Sie weist eine gedruckte Leiterplatte, ein an diese ansetzbares Gehäuseteil und Schutzelemente zum Spannungs- und Stromschutz auf. In die Leiterplatte sind Kontaktteile eingelötet, an denen die Schutzelemente für den Stromschutz gehalten und kontaktiert sind. Die Schutzelemente für den Spannungsschutz sind unmittelbar mit Leiterbahnen der Leiterplatte und mit einem Erdkontaktblech kontaktiert. Die Steckanschlußstellen sind mit den Kontaktteilen bzw. den Kontaktzonen für die Schutzelemente für den Spannungsschutz durch Leiterbahnen verbunden.

Die EP-A-0204675 offenbart ein Verteilerrahmenmodul mit einem Modulblock, an dessen Vorderseite zwei parallel verlaufende Reihen von Kabelanschlüssen und eine Reihe von Schutzbauteilöffnungen zwischen den Kabelanschlußreihen zur Aufnahme von Schutzbauteilen vorgesehen sind. Die Schutzbauteile weisen eine Leiterplatine mit darauf angebrachten Schutzelementen, wie z.B. Spannungsschutzelementen, auf.

Der Erfindung liegt die Aufgabe zugrunde, die Schutzbaugruppe in ihrem Aufbau zu vereinfachen und den Herstellungs- und Montageaufwand zu verringern.

Diese Aufgabe wird durch die Erfindung gemäß Anspruch 1 gelöst. Danach sind nun sämtliche Schutzelemente für die ankommenden und abgehenden Leitungen unmittelbar auf einer gemeinsamen Leiterplatte angelötet. Das Bestücken und Löten der Leiterplatte geschieht vor dem Aufsetzen des Gehäuseteils mit Hilfe von für die Leiterplatten üblichen Bestückungs- und Lötgeräten. Dadurch ist es möglich, diese hochentwickelte und leistungsfähige Technologie in entsprechend kostengünstiger Weise auch für die Schutzbaugruppen des Verteilers zu nutzen. Mit den doppelseitig offenen Durchbrüchen im Gehäuseteil, ist es möglich, dieses erst nachträglich auf die Leiterplatte aufzusetzen und z.B. mittels durchgehender Zapfen an der Leiterplatte klemmend zu fixieren.

Durch das direkte Anlöten der Schutzelemente an die Leiterplatte entfallen z.B. die Kontaktteile für die Stromschutzelemente, wodurch der Herstellungs- und Montageaufwand entsprechend verringert wird. Beim Ausfall eines der Schutzelemente wird die gesamte Baugruppe ausgewechselt und komplett überprüft. Die schadhaften Schutzelemente können durch manuelles Löten ausgewechselt werden.

Vorteilhafte Weiterbildungen der Erfindung sind in den Ansprüchen 2 bis 7 gekennzeichnet:

Durch die Weiterbildungen nach den Ansprüchen 2 und 3 ist es möglich, die Schutzelemente und Leiterbahnen so anzuordnen, daß kompakte Außenabmessungen für die Baugruppe erreicht werden können. Die schmalen Schutzelemente für den Stromschutz sind in einem engen Teilungsabstand angeordnet. Die voluminösen Schutzelemente für den Spannungsschutz sind auf zwei Reihen verteilt, wodurch die Breite des Schutzsteckers der Breite des Kontaktbauteils angepaßt werden kann.

Durch die Weiterbildung nach Anspruch 4 wird die Erdleiterbahn raumsparend im Überdeckungsbereich des Gehäuseteils angeordnet, so daß dafür kaum zusätzliche Leiterplattenfläche benötigt wird. Durch die Weiterbildung nach Anspruch 5 kann 'die Erdleiterbahn ungehindert von den übrigen Leiterbahnen über die gesamte Länge der Baugruppen geführt werden.

Durch die Weiterbildung nach Anspruch 6 ist es möglich, die Baugruppe im eingesteckten Zustand mit dem Trägerteil zu kontaktieren, ohne daß es dazu besonderer Federelemente am Trägerteil bedarf. Das Trägerteil kann z.B. mit einer vernickelten Oberfläche versehen sein, die sich für derartige Übergänge gut eignet. Die Erdkontaktfeder kann z.B. mit der Erdleiterbahn durch Löten verbunden sein.

Durch die Weiterbildung nach Anspruch 7 kann die Erdkontaktfeder in der Steckrichtung ohne große Auslenkung mit dem Trägerteil kontaktiert werden.

Im folgenden wird die Erfindung anhand eines in der Zeichnung dargestellten Ausführungsbeispieles näher erläutert. Es zeigen:
- Figur 1: eine perspektivische Ansicht eines Verteilerblocks mit Kontaktbauteilen und Schutzbaugruppen,
- Figur 2: einen Schnitt durch die Schutzbaugruppe nach Figur 1 mit einem der Kontaktbauteile entlang der Linie II - II in Figur 4,
- Figur 3: Eine Stirnseitenansicht der Schutzbaugruppe nach Figur 1,
- Figur 4: eine Draufsicht auf die Schutzbaugruppe nach Figur 3 mit einem Trägerteil für die Kontaktbauteile

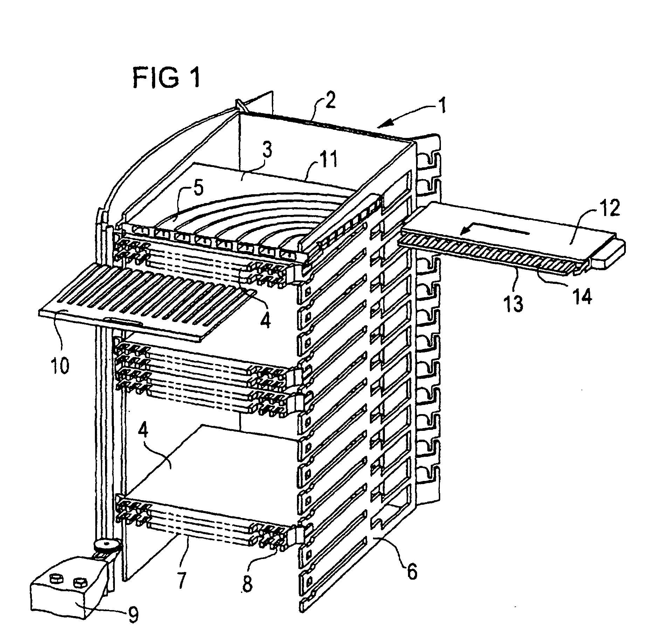

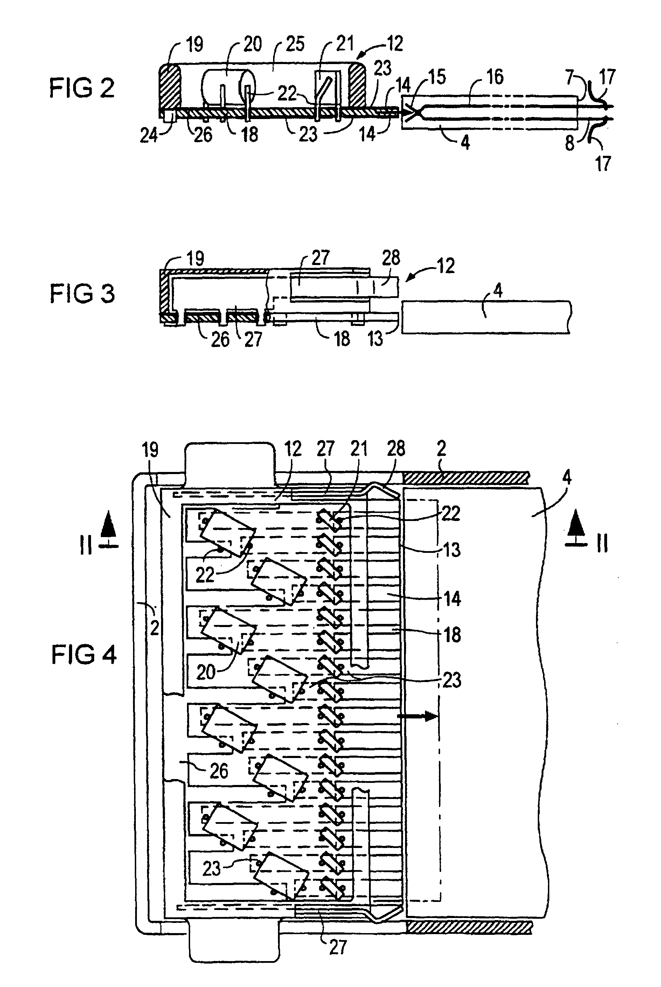

Figur 1 zeigt einen Verteilerblock 1 mit einem Trägerteil 2, in dem scheibenartige Drahtführungen 3 und Kontaktbauteile 4 sandwichartig übereinander gestapelt sind. Die Drahtführungen 3 weisen bogenförmig gekrümmte Drahtführungskanäle 5 auf, in denen ankommende und abgehende Leitungen (17, Fig. 2) von Seitenwänden 6 zu einer Bedienseite 7 des Verteilerblockes geführt werden können. Die Kontaktbauteile 4 sind an dieser Seite mit Schneidklemmen 8 versehen, in deren Klemmschlitze die ankommenden und abgehenden Leitungen mittels eines Anschlußwerkzeuges 9 kontaktgebend eingedrückt werden können. Die Schneidklemmen 8 sind mit Kontaktteilen verbunden, die im Inneren der Kontaktbauteile Trennkontakte bilden, die mittels von der Frontseite her einsteckbarer Trennstecker 10 unterbrochen werden können.

Die Kontaktbauteile 4 weisen auf ihrer der Bedienseite 7 gegenüberliegenden Rückseite 11 Steckkontakte für eine-seitlich in den Verteilerblock 1 einschiebbare Schutzbaugruppe 12 auf. Diese ist entlang ihrer dem Kontaktbauteil 4 zugewandten Frontseite 13 mit Steckkontaktstellen 14 versehen, die gemäß der angegebenen Pfeilrichtung zwischen die Steckkontakte der Kontaktbauteile 4 eingesteckt werden können.

Nach den Figuren 2, 3 und 4 sind die Steckkontaktstellen der Schutzbaugruppe 12 gemäß der angegebenen Pfeilrichtung zwischen Steckkontakte 15 von Kontaktteilen 16 des Kontaktbauteils 4 einsteckbar. Die Kontaktbauteile 16 sind auf der der Schutzbaugruppe 12 gegenüberliegenden Bedienseite 7 des Kontaktbauteils 4 mit den Schneidklemmen 8 verbunden, an denen die ankommenden und abgehenden Leitungen 17 angeschlossen sind.

Die Schutzbaugruppe 12 besteht aus einer Leiterplatte, einem rahmenartigen Gehäuseteil 19, Überspannungsableitern 20 und Stromsicherungen 21. Lötanschlüsse 22 der Überspannungsableiter 20 bzw. Stromsicherungen 21 sind über Leiterbahnen 23 mit den Steckkontaktstellen 14 der Leiterplatte 18 verbunden. Das Gehäuseteil 19 ist mittels Klemmzapfen 24 in entsprechenden Klemmlöchern der Leiterplatte 18 fixiert. Das Gehäuseteil 19 ist so ausgebildet, daß es auf die Leiterplatte 18 nach dem Anlöten der Schutzelemente (20,21) aufgesetzt werden kann. Dies wird durch einen zur Leiterplatte hin offenen Durchbruch 25 ermöglicht, der die Schutzelemente umschließt. Es ist aber auch möglich, für jedes einzelne Schutzelement oder für einzelne Gruppen der Schutzelemente jeweils einen Durchbruch vorzusehen.

Auf der der Frontseite 13 gegenüberliegenden Rückseite der Leiterplatte 18 verläuft eine Erdleiterbahn 26, die mit den Erdleiteranschlüssen der Überspannungsableiter 20 verbunden ist. Die Erdleiterbahn 26 ist im wesentlichen vom Gehäuseteil 19 raumsparend überdeckt. Sie ist bis in den Stirnseitenbereich der Leiterplatte 18 geführt und mit einer Erdkontaktfeder 27 verbunden, die sich entlang der Stirnseite der Schutzbaugruppe in deren Steckrichtung bis zur Frontseite (13) erstreckt. Beim Einstecken der Steckkontaktstellen 14 in die Steckkontakte 15 des Kontaktbauteils 4 setzt das als Federkontakt 28 ausgebildete freie Ende der Erdkontaktfeder 27 auf das metallische Trägerteil auf, das z.B. mit einer Chromund/oder Nickelschicht plattiert ist. Dadurch sind die Überspannungsabieiter nach dem Einstecken der Schutzbaugruppe 12 mit der Betriebserde des Verteilergestells verbunden.

## Patentansprüche

1. Schutzbaugruppe (12) zum Anstecken an ein Kontaktbauteil (4) eines Verteilers in einer Telekommunikationsanlage, wobei das Kontaktbauteil (4) mit einer Vielzahl von Kontaktteilen (16) zum Anschluß von ankommenden und abgehenden elektrischen Leitungen (17) versehen ist, wobei zumindest die Kontaktteile (16) für die ankommenden Leitungen (17) mit Steckkontakten (15) verbunden sind, die mit einer entsprechenden Vielzahl von Steckkontaktstellen (14) der Schutzbaugruppe (12) kontaktierbar sind, wobei die Steckkontaktstellen (14) entlang einer dem Kontaktbauteil (4) zugewandten Frontseite (13) der Schutzbaugruppe (12) zumindest in einer Reihe angeordnet sind, wobei die Schutzbaugruppe (12) eine gedruckte Leiterplatte (18), ein auf diese aufsetzbares Gehäuseteil (19) sowie Schutzelemente (z.B. 20, 21) zum Spannungsschutz und optional zum Stromschutz aufweist und wobei auf der Leiterplatte (18) gedruckte Leiterbahnen (23) vorgesehen sind, die von den Steckkontaktstellen zu den Schutzelementen verlaufen, **dadurch gekennzeichnet, daß** die mit Lötanschlüssen (22) versehenen Schutzelemente unmittelbar an die Leiterplatte (18) anlötbar sind, und daß das Gehäuseteil (19) mit Durchbrüchen (25) für die Schutzelemente versehen ist, welche Durchbrüche (25) sich quer zur Leiterplatte (18) durch die Oberseite und die Unterseite des Gehäuseteils (19) hindurcherstrecken, so daß das Gehäuseteil (19) nach dem Anlöten der Schutzelemente unter Aufnehmen derselben in den Durchbrüchen (25) auf die Leiterplatte (18) aufsetzbar ist.

2. Schutzbaugruppe nach Anspruch 1,
**dadurch gekennzeichnet,**
**daß** sich die Leiterbahnen (23) von den Steckkontaktstellen (14) unmittelbar zu den Anschlußstellen der Schutzelemente erstrecken.

3. Schutzbaugruppe nach Anspruch 1 oder 2,
**dadurch gekennzeichnet,**
**daß** die Schutzelemente zum Stromschutz als Stromsicherungen (21) und die Schutzelemente zum Spannungsschutz als zylindrische Überspannungsableiter (20) ausgebildet sind,
**daß** die Stromsicherungen (21) in einer zur Frontseite (13) parallelen Reihe in Nähe der Steckkontaktstellen (14) angeordnet sind,
**daß** die Überspannungsableiter (20) auf der den Steckkontaktstellen (14) abgewandten Rückseite der Stromsicherungen (21) angeordnet sind und
**daß** die Mittelachsen der Überspannungsableiter (20) parallel zur Leiterplatte (18) und schräg zur Frontseite (13) geneigt verlaufen.

4. Schutzbaugruppe nach Anspruch 1, 2 oder 3,
**dadurch gekennzeichnet,**
**daß** eine an die Überspannungsableiter (20) angeschlossene Erdleiterbahn (26) weitgehend vom Gehäuseteil (19) überdeckt ist.

5. Schutzbaugruppe nach Anspruch 4,
**dadurch gekennzeichnet,**
**daß** die Erdleiterbahn (26) entlang einer der Frontseite (13) gegenüberliegenden Rückseite der Leiterplatte (18) verläuft.

6. Schutzbaugruppe nach Anspruch 4 oder 5,
**dadurch gekennzeichnet,**
**daß** die Leiterplatte (18) mit zumindest einer Erdkontaktfeder (27) bestückt ist, die mit der Erdleiterbahn (26) verbunden ist und die mit einem Trägerteil (2) für die Aufnahme der Kontaktbauteile (4) kontaktierbar ist.

7. Schutzbaugruppe nach Anspruch 6,
**dadurch gekennzeichnet,**
**daß** die Erdkontaktfeder (27) senkrecht zur Frontseite der Schutzbaugruppe (12) in die Steckrichtung ragt und an ihrem freien Ende als Federkontakt (28) ausgebildet ist, der mit einer Seitenwand (6) des Trägerteils (2) kontaktierbar ist und senkrecht zu dieser auslenkbar ist.

## Revendications

1. Module de protection (12) destiné à être embroché sur un composant de contact (4) d'un répartiteur dans un système de télécommunication, le composant de contact (4) étant muni d'une pluralité d'éléments de contact (16) destinés à raccorder des câbles électriques (17) arrivants et partants, au moins les éléments de contact (16) destinés aux câbles (17) arrivants étant reliés à des contacts enfichables (15) qui peuvent être mis en contact avec une pluralité correspondante de points pour contacts enfichables (14) du module de protection (12), les points pour contacts enfichables (14) étant disposés le long d'une face avant (13) du module de protection (12) dirigée vers le composant de contact (4) au moins sur une rangée, le module de protection (12) présentant un circuit imprimé (18), une partie de boîtier (19) qui peut être montée sur celui-ci ainsi que des éléments de protection (par exemple 20, 21) pour la protection en tension et, en option, la protection en courant et des pistes conductrices imprimées (23) étant prévues sur le circuit imprimé (18), lesquelles s'étendent des points pour contacts enfichables vers les éléments de protection, **caractérisé en ce que** les éléments de protection munis de bornes à souder (22) peuvent être soudés directement sur le circuit imprimé (18) et que la partie de boîtier (19) est munie de traversées (25) pour les éléments de protection, lesquelles traversées (25) s'étendent transversalement par rapport au circuit imprimé (18) à travers le dessus et le dessous de la partie de boîtier (19) de manière à ce que la partie de boîtier (19) puisse être montée sur le circuit imprimé (18) après avoir soudé les éléments de protection en faisant passer ceux-ci dans les traversées (25).

2. Module de protection selon la revendication 1, **caractérisé en ce que** les pistes conductrices (23) s'étendent des points pour contacts enfichables (14) directement vers les points de raccordement des éléments de protection.

3. Module de protection selon la revendication 1 ou 2, **caractérisé en ce que** les éléments de protection destinés à la protection en courant sont réalisés sous la forme de fusibles électriques (21) et les éléments de protection destinés à la protection en tension sont réalisés sous la forme de parafoudres (20) cylindriques, que les fusibles électriques (21) sont disposés dans une rangée parallèle à la face avant (13) à proximité des points pour contacts enfichables (14), que les parafoudres (20) sont disposés sur le côté arrière des fusibles électriques (21) à l'opposé des points pour contacts enfichables (14) et que les axes médians des parafoudres (20) sont parallèles au circuit imprimé (18) et inclinés en biais par rapport à la face avant (13).

4. Module de protection selon la revendication 1, 2 ou 3, **caractérisé en ce qu'**une piste conductrice de terre (26) raccordée aux parafoudres (20) est largement recouverte par la partie de boîtier (19).

5. Module de protection selon la revendication 4, **caractérisé en ce que** la piste conductrice de terre (26) s'étend le long d'un côté arrière du circuit imprimé (18) qui est à l'opposé de la face avant (13).

6. Module de protection selon la revendication 4 ou 5, **caractérisé en ce que** le circuit imprimé (18) est équipé d'au moins un ressort de contact à la terre (27) qui est relié à la piste conductrice de terre (26) et qui peut entrer en contact avec un élément porteur (2) pour recevoir les composants de contact (4).

7. Module de protection selon la revendication 6, **caractérisé en ce que** le ressort de contact à la terre (27) dépasse perpendiculairement de la face avant du module de protection (12) dans le sens de l'embrochage et son extrémité libre est réalisée sous la forme d'un contact à ressort (28) qui peut entrer en contact avec une paroi latérale (6) de l'élément porteur (2) et être dévié perpendiculairement par rapport à celui-ci.

## Claims

1. Protective assembly (12) for plugging onto a contact component (4) of a distribution frame in a telecommunication system, the contact component (4) being provided with a multiplicity of contact parts (16) for connecting incoming and outgoing electric lines (17), in which arrangement at least the contact parts (16) for the incoming lines (17) are connected to plug contacts (15) which can be brought into contact with a corresponding multiplicity of plug contact positions (14) of the protective assembly (12), the plug contact positions (14) being arranged at least in one row along a front (13), facing the contact component (4), of the protective assembly (12), the protective assembly (12) exhibiting a printed circuit board (18), a housing part (19) which can be mounted on the latter and protective elements (e.g. 20, 21) for voltage protection and optionally for current protection, and printed conductor tracks (23) extending from the plug contact positions to the protective elements being provided on the circuit board (18), **characterized in that** the protective elements provided with solder connections (22) can be soldered directly to the circuit board (18), and **in that** the housing part (19) is provided with openings (25) for the protective elements, which openings (25) pass through the upper face and the lower face of the housing part (19), transversely with respect to the printed circuit board (18), so that the housing part (19) can be fitted to the printed circuit board (18) after the protective elements have been soldered on, and are held in the openings (25).

2. Protective assembly according to Claim 1,
**characterized in that**
the conductor tracks (23) extend directly from the plug contact positions (14) to the connecting positions of the protective elements.

3. Protective assembly according to Claim 1 or 2, **characterized in that**
the protective elements for current protection are constructed as current fuses (21) and the protective elements for voltage protection are constructed as cylindrical overvoltage arrestors (20),
that the current fuses (21) are arranged in the vicinity of the plug contact positions (14) in a row parallel to the front end (13),
that the overvoltage arrestors (20) are arranged at the rear of the current fuses (21) facing away from the plug contact positions (14) and
that the centre axes of the overvoltage arrestors (20) extend in parallel with the circuit board (18) and inclined obliquely with respect to the front end (13).

4. Protective assembly according to Claim 1, 2 or 3, **characterized in that**
an earth conductor track (26) connected to the overvoltage arrestors (20) is largely covered by the housing part (19).

5. Protective assembly according to Claim 4,
**characterized in that**
the earth conductor track (26) extends along a rear of the circuit board (18) which is opposite the front end (13).

6. Protective assembly according to Claim 4 or 5, **characterized in that**
the circuit board (18) is equipped with at least one earth contact spring (27) which is connected to the earth conductor track (26) and which can be brought into contact with a support part (2) for accommodating the contact components (4).

7. Protective assembly according to Claim 6,
**characterized in that**
the earth contact spring (27) protrudes perpendicularly to the front end of the protective assembly (12) in the plug-in direction and is constructed at its free end as spring contact (28) which can be brought into contact with a side wall (6) of the support part (2) and can be deflected perpendicularly to the latter.
